# EUROPEAN PATENT SPECIFICATION

(11) **EP 0 289 956 B1**
(45) Date of publication and mention of the grant of the patent: **11.08.1993**
(21) Application number: 88106925.6
(22) Date of filing: 29.04.1988
(51) Int. Cl.: H05K 5/06

(54) **Sealing structure for an electronic component**
Dichtungsstruktur für ein elektronisches Teil
Structure étanche pour un composant électronique

(30) Priority: 07.05.1987 JP 68783/87 U
(43) Date of publication of application: 09.11.1988
(73) Proprietor: OMRON TATEISI ELECTRONICS CO., Kyoto 616 (JP)
(72) Inventor: Nakai, Hideo Omron Tateisi Electronics Co., Nagaokakyo-City Kyoto-fu (JP); Hosoya, Masakatsu Omron Tateis Electronics Co., Nagaokakyo-City Kyoto-fu (JP)
(74) Representative: WILHELMS, KILIAN & PARTNER Patentanwälte

(56) References cited:
- DE-A- 3 726 357
- US-A- 3 383 565
- US-A- 4 552 626
- US-A- 4 600 969

## Description

The present invention relates to a method for sealing an electronic component part having a fluoride resin casing filled with resin material such as epoxy resin for sealing purpose. The electronic component may be an electronic switch such as a proximity switch, a photoelectric switch and so on among other possibilities.

Conventionally, proximity switches or the like have often been used in harsh environments where moisture, oil, acid, alkaline substances, welding spatters, and other substances harmful to the proper functioning of the switches are present. Therefore, they are typically sealed against such harmful substances in various manners. A typical mode of sealing a proximity switch (which is often used in harsh environments of manufacturing plants) consists of filling a casing of a proximity switch with resin material such as epoxy resin.

A proximity switch is intended to detect metallic objects in the vicinity but may produce a false signal when welding spatter is deposited on the casing of the switch. Therefore, proximity switches which are to be used in environments where spatter deposition may occur are typically provided with fluoride resin (or Teflon; trade name) casings so that spatter deposition may be readily removed. By the use of a fluoride resin casing, spatter deposition can be easily removed so as to recover proper functioning of the proximity switch.

However, since the affinity between the fluoride resin casing and the resin material such as epoxy resin which is filled into the casing is so poor that the filling of epoxy resin into the casing may not produce the intended sealing effect against moisture, oil, acid and other substances. In particular, moisture may pass through the gap between the casing and the resin filled therein and may reach the internal electronic circuit unit. This may lower the insulation resistance of the proximity switch to such an extent to cause faulty action of the proximity switch.

US-A-4 600 969 discloses an electric component part comprising a casing with an end closed by a cap and an open end from which a cord extends. The interior of the casing in which an electric circuit is disposed is filled with a potting compound.

US-A-4 552 626 discloses an electroless process for metal plating filled thermoplastic resins.

In view of such problems of the prior art, a primary object of the present invention is to provide a method for sealing an electronic component part such as a proximity switch having an improved sealing capability.

A second object of the present invention is to provide a sealing structure for an electronic component part which is simple but is highly effective.

According to the present invention, these and other objects of the present invention can be accomplished by a method as defined in claim 1.

Thus, according to the present invention, the interior surface of the fluoride resin casing is processed with metallic sodium for giving the surface of the fluoride resin the capability to attach to the resin material that is filled therein. Therefore, the resin such as epoxy resin filled into the casing can closely attach to the inner wall surface of the casing with the result that the water resistance and the oil resistance of the electronic component part are much improved.

When the electronic component part consists of a proximity switch, preferably, the casing is substantial cylindrical in shape and is provided with an open end and a closed end; a coil element being disposed adjacent to the closed end while a cord extends from the open end by way of a cord clamp fitted into the open end with a circuit board arranged therebetween. Thus, a highly compact and highly water resistant structure can be obtained.

Now the present invention is described in the following in terms of a specific embodiment with reference to the appended drawing which shows a sectional view of a proximity switch to which the sealing structure of the present invention is applied.

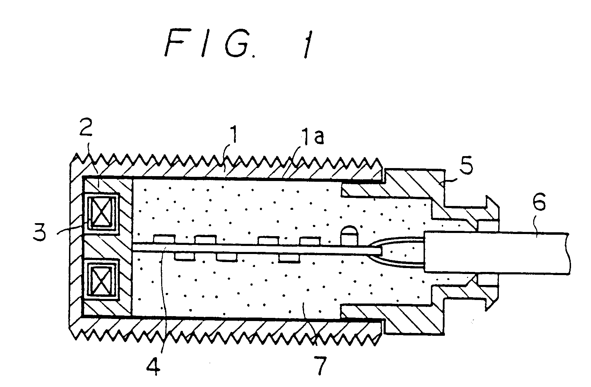

Figure 1 is a sectional view of a proximity switch of a high frequency oscillation type to which a preferred embodiment of the present invention is applied. It comprises a cylindrical casing 1 having an open end and a closed end at either axial end thereof and is provided with a threaded portion on its outer periphery.

In this embodiment, the inner wall surface 1a of the fluoride resin casing 1 is processed with metallic sodium in advance. It can be accomplished in a number of ways. For instance, the casing 1 may be dipped into liquidus sodium for processing its inner surface. Metallic sodium removes fluoride atoms on the surface which are coupled to the chains of carbon atoms of the fluoride resin, and exposure of the surface of the fluoride resin to the air causes the exposed carbon chains to be fitted with active bases such as hydrocarbon bases, carbonyl bases, carboxyl bases and so on with the result that the surface is given with the capability to attach to the resin.

Further, a disk-shaped core 2 having an annular groove in its front end surface for fitting a coil 3 therein is fixedly fitted into the front end or the closed end of the casing 1. Behind this core 2 is fitted, along the longitudinal direction of the casing 1, a printed circuit board 4 carrying an electronic circuit for detecting the presence of an object in the vicinity by a change in the output of an oscillation circuit including the coil 3. In the rear end or the open end of the casing 1 is fitted a cord clamp 5 for enclosing the casing 1 and retaining a cord 6 passed therethrough. The interior of the casing 1 is filled with resin 7 such as epoxy resin for sealing the interior of the casing 1 and to fixedly secure the internal components.

According to the present invention, since the internal wall surface 1a of the casing 1 is processed with metallic sodium for rendering the surface capable of attaching to the epoxy resin 7, the affinity between the casing 1 and the epoxy resin 7 filled therein is much improved and the resin filled therein can positively prevent the infiltration of water into the casing 1. Therefore, the water resistance of the proximity switch is much improved.

The above described embodiment pertained to a proximity switch of a high frequency oscillation type, but it is obvious that the present invention can be equally applied to the casing structures of various other electronic components including various switches such as proximity switches in the forms of photoelectric switches, ultrasonic switches and so on.

## Claims

1. A method for sealing an electronic component part having a casing (1) made of fluoride resin material and a sealing member made of a second resin material (7) filled into the casing, characterized in that an internal wall surface of the casing (1) is processed with metallic sodium before the second resin material is filled into the casing (1).

2. A method as defined in claim 1, wherein the processing of an internal wall surface of the casing (1) is by dipping the casing into liquid metallic sodium.

3. A method as defined in claim 1 or 2, wherein the second resin material filled into the casing (1) is epoxy resin.

4. A method as defined in anyone of the preceding claims, wherein the electric component part is a proximity switch.

## Patentansprüche

1. Verfahren zur Versiegelung eines elektronischen Bauteils, welches ein Gehäuse (1) aus Fluorharz und ein Siegelungsteil aus einem zweiten Harz (7), das in das Gehäuse eingefüllt ist, aufweist, dadurch gekennzeichnet, daß eine Innenwandoberfläche des Gehäuses (1) mit metallischem Natrium beehandelt wird, bevor das zweite Harz in das Gehäuse (1) eingefüllt wird.

2. Verfahren nach Anspruch 1, bei welchem die Behandlung der Innenwandoberfläche des Gehäuses (1) durch Tauchen des Gehäuses in flüssiges metallisches Natrium erfolgt.

3. Verfahren nach Anspruch 1 oder 2, bei welchem das in das Gehäuse (1) gefüllte zweite Harz Epoxidharz ist.

4. Verfahren nach irgendeinem der vorstehenden Ansprüche, bei welchem das elektrische Bauteil ein Näherungsschalter ist.

## Revendications

1. Un procédé pour fermer hermétiquement un élément de composant électronique possédant un boitier (1) réalisé en un matériau à base de résine fluorée et un organe de scellement réalisé en un second matériau à base de résine (7) qui remplit le boitier, caractérisé par le fait que une surface de paroi interne du boitier (1) est traitée à l'aide de sodium métallique avant que le second matériau à base de résine ne soit déversé dans le boitier (1).

2. Procédé selon la revendication 1, dans lequel le traitement de la surface de paroi interne du boitier (1) consiste à plonger le boitier dans du sodium métallique liquide.

3. Procédé selon l'une des revendications 1 ou 2, dans lequel le second matériau à base de résine qui remplit le boitier (1) est une résine époxy.

4. Procédé selon l'une des revendications précédentes, dans lequel l'élément de composant électronique est un capteur-interrupteur de proximité.
